# EUROPEAN PATENT APPLICATION

(11) **EP 2 830 100 A1**
(43) Date of publication of application: **28.01.2015**
(21) Application number: 12872016.6
(22) Date of filing: 21.03.2012
(51) Int. Cl.: H01L 31/04

(54) **SOLAR CELL MODULE**

(71) Applicant: Sanyo Electric Co., Ltd., Moriguchi-shi, Osaka 570-8677 (JP)
(72) Inventor: TAIRA, Shigeharu, Moriguchi-shi Osaka 570-8677 (JP); NISHIWAKI, Takeshi, Moriguchi-shi Osaka 570-8677 (JP)
(74) Representative: Glawe, Delfs, Moll
(86) International application number: PCT/JP2012/057211
(87) International publication number: WO 2013/140553

(57) **Abstract**

A solar cell module with improved moisture resistance is to be provided.

A solar cell module (1) is provided with a solar cell (10), a first protection member (14), a second protection member (15), and a sealing material (13). The first protection member (14) is disposed at a first side of the solar cell (10). The second protection member (15) is made of a resin sheet that is disposed at a second side of the solar cell (10). A sealing material (13) is disposed between the first protection member (14) and the second protection member (15). The sealing material (13) seals the solar cell (10). The solar cell (10) includes a photoelectric conversion body (10a) and an electrode (21). The electrode (21) is disposed above the photoelectric conversion body (10a). The electrode (21) contains a conductive material and a polyether-based urethane resin.

## Description

### TECHNICAL FIELD

The invention relates to a solar cell module.

### BACKGROUND ART

Patent Document 1 discloses a solar cell including an electrode formed of a silver paste.

### PRIOR ART DOCUMENT

### PATENT DOCUMENT

Patent Document 1: Japanese Patent Application Publication No. 2009-253096

### SUMMARY OF THE INVENTION

### PROBLEM TO BE SOLVED BY THE INVENTION

There is a demand for improvement of the moisture resistance of a solar cell module.

A main object of the invention is to provide a solar cell module with improved moisture resistance.

### MEANS FOR SOLVING THE PROBLEM

A solar cell module according to the invention is provided with a solar cell, a first protection member, a second protection member, and a sealing material. The first protection member is disposed at a first side of the solar cell. The second protection member is made of a resin sheet that is disposed at a second side of the solar cell. A sealing material is disposed between the first protection member and the second protection member. The sealing material seals the solar cell. The solar cell includes a photoelectric conversion body and an electrode. The electrode is disposed above the photoelectric conversion body. The electrode contains a conductive material and a polyether-based urethane resin.

### EFFECT OF THE INVENTION

The invention can provide a solar cell module with improved moisture resistance.

### BRIEF DESCRIPTION OF THE DRAWINGS

[Fig. 1] Fig. 1 is a schematic cross-sectional view of a solar cell module according to an embodiment of the invention.

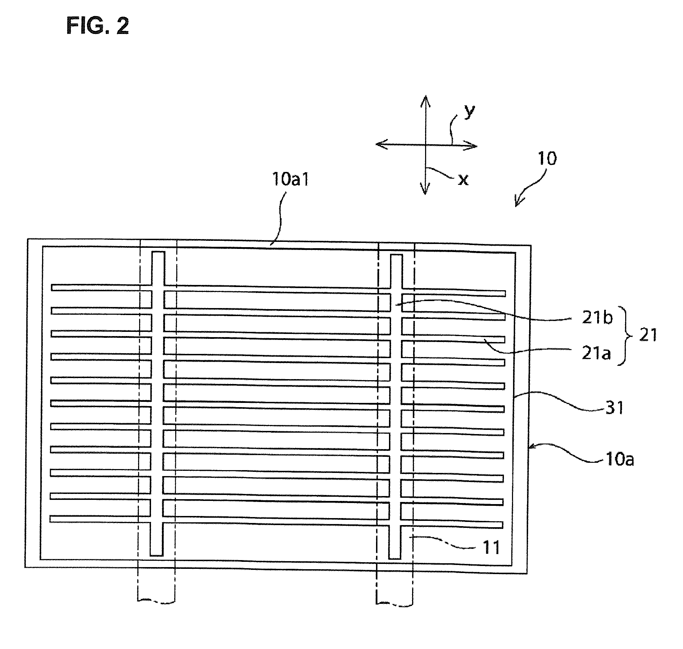

[Fig. 2] Fig. 2 is a schematic plan view of a solar cell according to the embodiment of the invention.

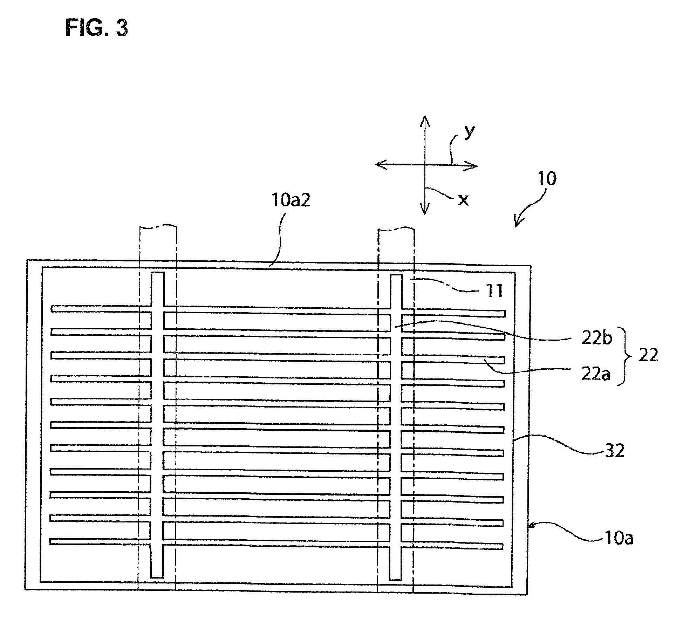

[Fig. 3] Fig. 3 is a schematic back side view of the solar cell according to the embodiment of the invention.
[Fig. 4] Fig. 4 presents a ratio of a curve factor (F.F. : Fill Factor) in a solar cell module of an example to a curve factor (F.F.) in the solar cell module of a comparative example ((the curve factor (F.F.) in the solar cell module of the example)/(the curve factor (F.F.) in the solar cell module of the comparative example)).

### MODE FOR CARRYING OUT THE INVENTION

Hereinafter, examples of preferred embodiments carrying out the invention are described. It should be noted that the following embodiments are provided just for illustrative purposes. The invention should not be limited at all to the following embodiments.

In the drawings referred to in the embodiments and other parts, components having substantially the same function are referred to with the same reference numeral. In addition, the drawings referred to in the embodiments and other parts are illustrated schematically, and the dimensional ratio and the like of objects depicted in the drawings are different from those of actual objects in some cases. The dimensional ratio and the like of objects are also different among the drawings in some cases. The specific dimensional ratio and the like of objects should be determined with the following description taken into consideration.

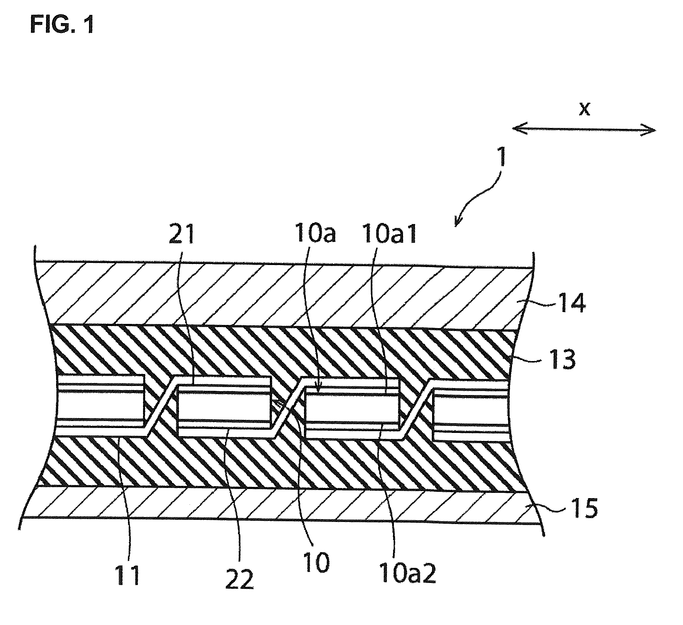

As illustrated in Fig. 1, solar cell module 1 includes multiple solar cells 10 electrically connected to each other by wiring materials 11. Here, a solar cell module may include only one solar cell, indeed.

Solar cell 10 includes photoelectric conversion body 10a. Photoelectric conversion body 10a generates carriers such as electrons and holes when receiving light. Photoelectric conversion body 10a may generate carriers only when receiving light on one main surface 10a1. Photoelectric conversion body 10a may generate power not only when receiving light on one main surface 10a1, but also when receiving light on other main surface 10a2. Photoelectric conversion body 10a may include a substrate made of a semiconductor material, for example. Specifically, photoelectric conversion body 10a may include, for example, a crystal silicon substrate, and a p-type semiconductor layer and an n-type semiconductor layer that are disposed on the crystal silicon substrate. Instead, Photoelectric conversion body 10a may include, for example, a crystal silicon substrate including a p-type dopant diffusion region and an n-type dopant diffusion region that are exposed on the surface of the substrate.

First and second electrodes 21, 22 are disposed on photoelectric conversion body 10a. Specifically, first electrode 21 is disposed on main surface 10a1. Second electrode 22 is disposed on main surface 10a2. One of first and second electrodes 21, 22 is an electrode that collects majority carriers, and the other one is an electrode that collects minority carriers.

First electrode 21 includes multiple finger portions 21a, and bus bar portions 21b. Multiple finger portions 21a are arranged at intervals in X-axis direction. Multiple finger portions 21a are electrically connected to bus bar portions 21b. First electrode 21 is electrically connected to wiring materials 11 mainly at bus bar portions 21b.

Second electrode 22 includes multiple finger portions 22a, and bus bar portions 22b. Multiple finger portions 22a are arranged at intervals in X-axis direction. Multiple finger portions 22a are electrically connected to bus bar portions 22b. Second electrode 22 is electrically connected to wiring materials 11 mainly at bus bar portions 22b.

Transparent conductive oxide layer 31 is disposed between first electrode 21 and main surface 10a1. Transparent conductive oxide layer 31 is disposed so as to cover substantially entire main surface 10a1. Transparent conductive oxide layer 32 is disposed between second electrode 22 and main surface 10a2. Transparent conductive oxide layer 32 is disposed so as to cover substantially entire main surface 10a2. Transparent conductive oxide layers 31, 32 can be each made of, for example, indium tin oxide (ITO) or the like.

First protection member 14 is disposed at one side of solar cell 10. Second protection member 15 is disposed at the other side of solar cell 10. Sealing material 13 is disposed between first protection member 14 and second protection member 15. Sealing material 13 seals solar cells 10. First protection member 14 located at a light-receiving side of solar cells 10 is made of a glass plate, a ceramic plate, or a resin plate. Second protection member 15 located at a back side of solar cells 10 is made of a resin sheet not containing a barrier layer such as a metal layer or an inorganic oxide layer. Sealing material 13 can be made of, for example, a cross-linking resin such as an ethylene-vinyl acetate copolymer or a non-crosslinking resin such as polyolefin.

As a binder resin for the electrodes, an ester-based urethane resin synthesized with ester-based polyol is generally used. This is because use of the ester-based urethane resin results in improvement of the mechanical strength and the heat resistance of the electrodes.

The ester-based urethane resin is hydrolytic. However, the hydrolyzability of the ester-based urethane resin has not been recognized as a problem in use of an ester-based urethane resin as an electrode material for solar cells. This is because the solar cell is sealed with a sealing material and thus moisture rarely gets into the electrodes. Moreover, this is because, even if slight quantity of moisture gets into the electrodes to hydrolyze the ester-based urethane resin, the electric resistance of the electrodes themselves does not increase. Accordingly, the photoelectric conversion efficiency of the solar cell has been considered not to be lowered with the hydrolysis of the ester-based urethane resin.

However, as a result of intensive studies, the inventors have found that the hydrolysis of the ester-based urethane resin results in increase in the electric resistance in an interface between the electrodes and the photoelectric conversion body or the transparent conductive oxide layers. The inventors have found that if a transparent conductive oxide layer is provided between electrodes and a photoelectric conversion body, in particular, the interface resistance between the electrodes and the transparent conductive oxide layers tends to increase with the hydrolysis of the ester-based urethane resin. One of conceivable reasons for this tendency is that the hydrolysis of the ester-based urethane resin lowers the adhesion of the electrodes to the photoelectric conversion body or the transparent conductive oxide layers.

In solar cell module 1, electrodes 21, 22 contain a polyether-based urethane resin. The polyether-based urethane resin is a resin containing a polyether-based polyol unit. The polyether-based urethane resin is more resistant to hydrolysis than the ester-based urethane resin. Thus, the adhesion of electrodes 21, 22 containing the polyether-based urethane resin to transparent conductive oxide layers 31, 32 is less likely to be lowered. This makes it less likely to increase the interface resistance between electrodes 21, 22 and transparent conductive oxide layers 31, 32. Accordingly, solar cell module 1 has improved moisture resistance.

In solar cell module 1, second protection member 15 is made of a resin sheet not containing a barrier layer such as a metal layer or an inorganic oxide layer. This results in the high moisture permeability of second protection member 15. Accordingly, moisture is likely to get into sealing material 13, and electrodes 21, 22 are likely to come into contact with the moisture. To cope with this, it is effective that electrodes 21, 22 are made of a polyether-based urethane resin having resistance to hydrolysis.

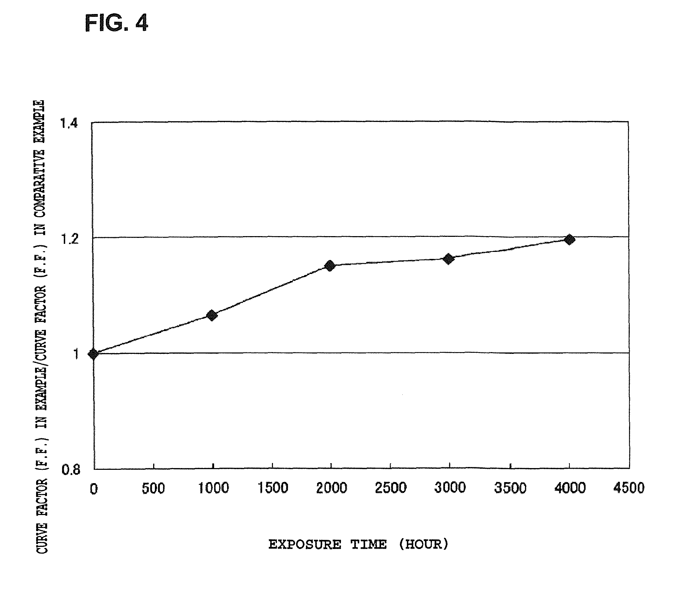

Actually, fabricated are a solar cell module (example) in which a polyether-based urethane resin is used as an electrode binder and a solar cell module (comparative example) in which an ester-based urethane resin is used as an electrode binder. The solar cell modules fabricated in the example and the comparative example are exposed in an atmosphere at a humidity of 85% and a temperature of 85°C, and curve factors (F.F. : Fill Factor) of them are measured at each exposure time. Fig. 4 illustrates the ratio of the curve factor (F.F.) in the solar cell module of the example to the curve factor (F.F.) in the solar cell module of the comparative example at each time.

From a result illustrated in Fig. 4, it is observed that the electrodes containing the polyether-based urethane resin can improve the moisture resistance of the solar cell module.

The polyether-based urethane resin preferably includes a urethane resin formed by addition reaction of a compound including an isocyanate group and polyether polyol.

Specific examples preferably usable as the compound including an isocyanate group are: for example, aromatic polyisocyanate such as tolylene diisocyanate, diphenylmethane diisocyanate, polymethylene polyphenyl polyisocyanate, tolidine diisocyanate, xylylene diisocyanate, naphthalene diisocyanate; aliphatic polyisocyanate such as hexamethylene diisocyanate, isophorone diisocyanate, hydrogenated xylylene diisocyanate, dicyclohexyl methane diisocyanate, octamethylene diisocyanate and trimethyl hexamethylene diisocyanate; mixtures thereof, and the like. Among these polyisocyanate compounds, a compound containing three or more nuclei of polymethylene polyphenyl polyisocyanate in the component has lower resistance. Moreover, a compound containing a terminal isocyanate group synthesized by reaction of polyisocyanate and polyol can be used as a compound including an isocyanate group. The polyol in this case is not particularly limited, and general polyether polyols, polyester polyols, polycarbonate polyols or the like can be used. A blocking agent for the compound including an isocyanate group is also not particularly limited, and imidazoles, phenols, oximes or the like can be used.

Specific examples preferably usable as polyether polyol are, for example, polypropylene glycol, polyoxypropylene glycol, polyoxytetramethylene glycol, mixtures thereof, and the like.

### (Modification Example)

Electrodes may be disposed directly on a photoelectric conversion body. In other words, a transparent conductive oxide layers are not necessarily to be disposed between the electrodes and the photoelectric conversion body.

Electrodes may be provided in such a planar form as to cover the substantially entire surface of the photoelectric conversion body at the back side of the solar cell. The solar cell may be a back contact solar cell. In these cases, many electrode materials are used on the back side of the solar cell. Second protection member 15 described above is disposed at the back side of the solar cell. Accordingly, when an electrode at the back side of the solar cell includes a resin containing a polyether-based urethane resin, the electrode at the back side of the solar cell less suffers from hydrolysis due to the moisture getting into the electrode from a second protection member 15 side.

### EXPLANATION OF THE REFERENCE NUMERALS

- 1: solar cell module
- 10: solar cell
- 10a: photoelectric conversion body
- 13: sealing material
- 14: first protection member
- 15: second protection member
- 21: first electrode
- 22: second electrode
- 31, 32: transparent conductive oxide layer

## Claims

1. A solar cell module comprising:
a solar cell;
a first protection member disposed at a first side of the solar cell; and
a second protection member disposed at a second side of the solar cell and made of a resin sheet; and
a sealing material disposed between the first protection member and the second protection member, and sealing the solar cell, wherein
the solar cell includes:
a photoelectric conversion body; and
an electrode disposed on the photoelectric conversion body, and containing a conductive material and a polyether-based urethane resin.

2. The solar cell module according to claim 2, wherein the polyether-based urethane resin contains an urethane resin formed by an addition reaction of a compound including an isocyanate group and polyether polyol.

3. The solar cell module according to claim 1 or 2, further comprising a transparent conductive oxide layer disposed between the photoelectric conversion body and the electrode.

4. The solar cell module according to any one of claims 1 to 3, wherein
the electrode is provided in such a planar form as to cover an substantially entire surface of the photoelectric conversion body at the second side of the solar cell.

5. The solar cell module according to any one of claims 1 to 4, wherein
the solar cell is a back contact solar cell.
